# EUROPEAN PATENT APPLICATION

(11) **EP 4 801 214 A2**
(43) Date of publication of application: **02.09.2026**
(21) Application number: 26161501.7
(22) Date of filing: 28.02.2026
(51) Int. Cl.: H05K 7/20

(54) **RACK-LEVEL SUPERCRITICAL CO2 AND HEAT PUMP SYSTEM FOR ENERGY RECOVERY IN DATA CENTERS**

(30) Priority: 01.03.2025 US 202563765557 P
(71) Applicant: Hoareau, Jordan-Elie, 02100 Saint-Quentin Aisne (FR)
(72) Inventor: Hoareau, Jordan-Elie, 02100 Saint-Quentin Aisne (FR)

(57) **Abstract**

A rack-level energy recovery system for data centers comprises a first insulated enclosure (Enclosure 1) housing computing equipment generating waste heat at 40-120°C, and a second insulated enclosure (Enclosure 2) adjacent thereto containing a heat exchanger, a heat pump configured to extract the waste heat, cool the computing equipment, and output amplified heat at a higher temperature, and a supercritical CO₂ (sCO₂) power cycle utilizing the amplified heat to generate electricity, with a closed-loop fluid circuit recycling byproduct heat and cooling to increase total heat input by at least 50% and achieve net energy recovery with minimal external waste; the system is scalable from 0.5 kW to at least 500 kW per rack, retrofittable to existing infrastructure, and controlled dynamically via sensors and VFDs (variable frequency drives) for optimal efficiency.

## Description

### CROSS-REFERENCE TO RELATED APPLICATIONS

This application claims priority to the U.S. Provisional Application No. 63/765,557, filed March 1, 2025, the contents of which are incorporated by reference

### STATEMENT REGARDING FEDERALLY SPONSORED RESEARCH

Not Applicable

### SEQUENCE LISTING

Not Applicable

### BACKGROUND OF THE INVENTION

High-performance servers-like those powering Al (artificial intelligence) or cloud services-generate massive heat. That heat isn't just a nuisance; it's a $13.5 billion annual drain in the U.S. alone. Cooling accounts for 40-50% of data center power consumption.
Metric : Cooling Waste | Value : 40-50% | Source : EIA, 2024
Metric : U.S Cost (2024) | Value : $13.5B | Source : Synergy Research
Traditional systems (fans, CRAC (Computer Room Air Conditioning), liquid cooling) dissipate heat without recovery, creating energy and thermal crossover inefficiencies.

While sCO₂ (supercritical carbon dioxide) cycles are known in industrial WHR (waste heat recovery) (e.g., Echogen) and heat pumps in HVAC (heating, ventilation, and air conditioning), no prior art integrates both at rack level with closed-loop byproduct recycling in data centers. The present invention solves this by transforming waste heat into electricity at the source.

### SUMMARY OF THE INVENTION

The invention is a modular rack-level energy recovery system with dual insulated enclosures: one for computing (Enclosure 1), one for machinery (Enclosure 2). A heat pump extracts waste heat, cools servers, and outputs amplified heat. An sCO₂ (supercritical CO₂) power cycle converts this into electricity. A closed-loop circuit recycles all byproducts, achieving near-zero waste and ~59% system efficiency. A new rack architecture enables plug-and-play integration.

### BRIEF DESCRIPTION OF THE DRAWINGS

- FIG. 1: System schematic with heat, cooling, and electricity flows

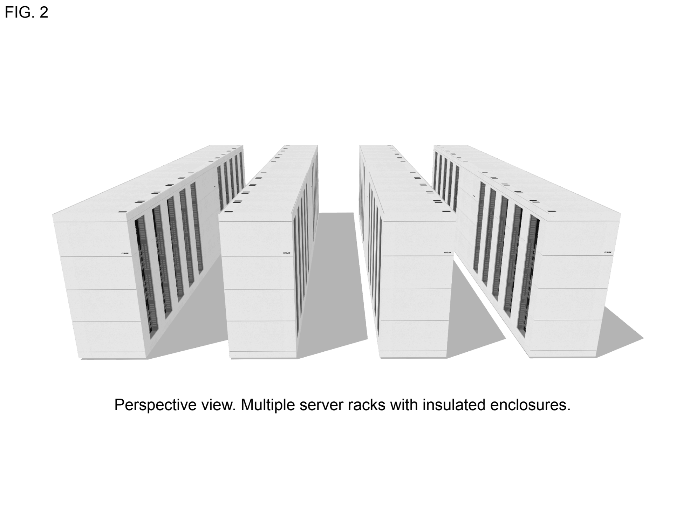

- FIG. 2: Perspective view. Multiple server racks with insulated enclosures.

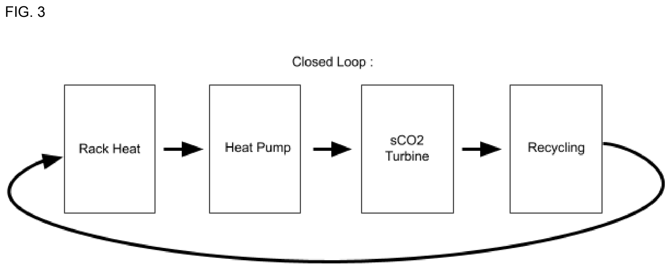

- FIG. 3: Closed-loop process flow
- FIG. 4: Performance vs. pressure table
- FIG. 5: Control system with sensors and VFDs (variable frequency drives)

### DETAILED DESCRIPTION

**The system comprises:**
a) A first insulated enclosure (Enclosure 1) housing computing equipment (0.5 kW to 500 kW per rack, 40-120°C exhaust)
b) A second insulated enclosure (Enclosure 2) adjacent thereto, containing:
   i) A heat exchanger (~0 kW electrical input)
   ii) A heat pump (5-25 kW input, COP (coefficient of performance) 2-6, boosts heat by 10-60°C)
   iii) An sCO₂ (supercritical CO₂) Brayton cycle (74-500 bar, 1-7 pressure ratio, 30-70% cycle efficiency)

The dual-enclosure rack system may be retrofitted or manufactured as a single unit with thermal separation and fluid pathways.

Heat is captured via air, liquid, or immersion exchangers. The heat pump cools servers to 20-50°C while amplifying heat to 60-140°C. Byproduct heat (30-70°C) is recycled.

The sCO₂ (supercritical CO₂) cycle includes compression, heat addition, expansion, and cooling, with optional recuperation. Turbine output: 30-60% of rack power.

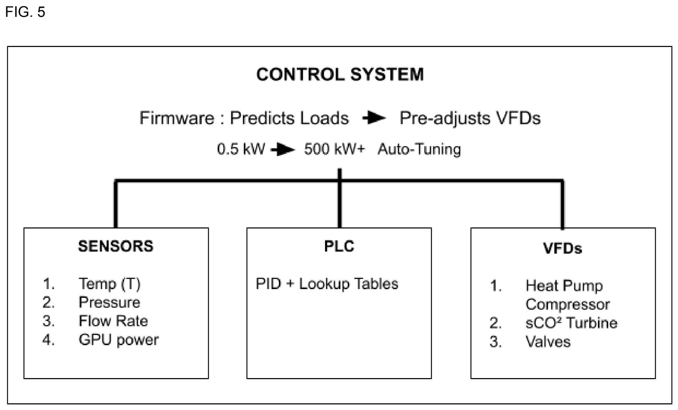

FIG. 5 illustrates the control system. Sensors (1) measure temperature (T), pressure (P), flow rate, and GPU (graphics processing unit) power draw. These signals feed into a PLC (programmable logic controller) (2) running firmware that:
a) Analyzes real-time and historical data to predict thermal load,
b) Pre-adjusts VFDs (variable frequency drives) (3) for:
   i) Heat pump compressor speed,
   ii) sCO₂ (supercritical CO₂) compressor speed,
   iii) Expansion and bypass valve timing.
The firmware uses PID (proportional-integral-derivative) control and lookup tables to maintain optimal COP (coefficient of performance) and maximize net electricity output across rack loads from 0.5 kW to 500 kW and beyond.

The system integrates with CRAC (Computer Room Air Conditioning), liquid loops, or immersion cooling via bypass valves.

### OPERATION

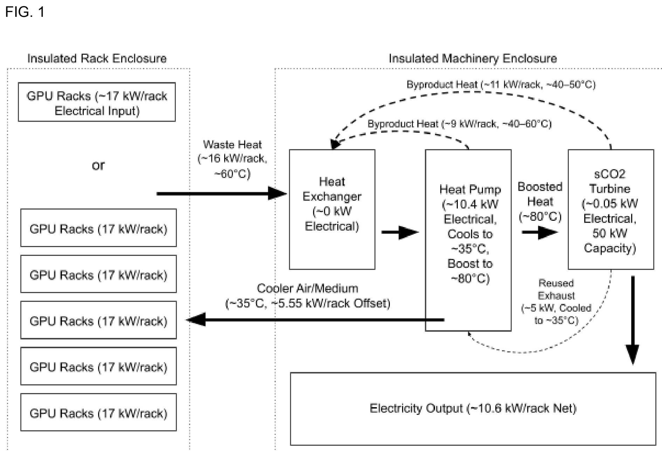

FIG. 1 illustrates one working embodiment for a rack consuming approximately 17 kW of electrical input. In Enclosure 1, waste heat from GPU racks (~60°C, ~17 kW/rack electrical input) is trapped by insulated panels. This heat is transferred via air or liquid medium to a heat exchanger located in Enclosure 2, which consumes negligible electrical power and delivers approximately 16 kW/rack of heat after minor internal losses. The heat pump, consuming approximately 10.4 kW/rack, cools the racks by returning air or medium at approximately 35°C to offset ~5.55 kW/rack of cooling needs, while boosting the ~16 kW of extracted heat to approximately 80°C. Within Enclosure 2, byproduct heat from the heat pump (~9 kW, ~40-60°C) and turbine (~11 kW, ~40-50°C) is captured and reused by returning to the heat exchanger via a closed-loop fluid circuit, with approximately 5 kW of turbine exhaust at ~40°C cooled to approximately 35°C by the heat pump and combined with the rack cooling output, reinjected into Enclosure 1 as a total cooling offset of approximately 10.6 kW at ~35°C, minimizing external waste to near-zero (~1 kW/rack internal losses at ~60°C). The combined heat (~37 kW at ~80°C) feeds the sCO₂ (supercritical CO₂) turbine, which consumes approximately 0.05 kW/rack and produces approximately 10.6 kW/rack of net electricity. The system consumes a total of approximately 27.5 kW/rack of electrical input and outputs approximately 16.15 kW/rack (~95% of GPU input).

### SCALABILITY

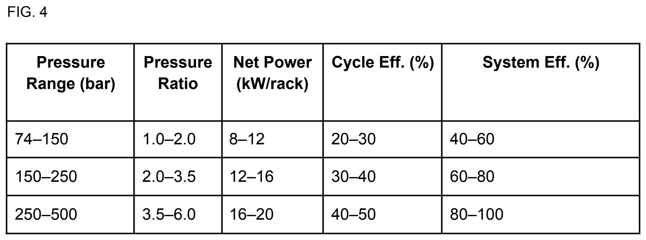

The system is fully scalable from 0.5 kW (edge computing) to 500 kW and beyond (hyperscale AI) per rack. FIG. 4 shows performance across pressure ranges up to 500 bar. All components scale proportionally via increased fluid flow rates, compressor capacities, heat transfer surface areas, and pressure ratings, while maintaining the same closed-loop energy recovery efficiency, 2.3× energy multiplier, and near-zero waste. The example in FIG. 1 is illustrative; actual performance scales linearly with rack power density.

**TABLE 1 - SYSTEM COMPONENTS (FIG. 1)**

| |
|---|
| Ref. 1 \| Component : GPU Racks \| Function : Generate ~17 kW/rack electrical input, ~16 kW waste heat @ ~60°C |
| Ref. 2 \| Component : Heat Exchanger \| Function : Transfers heat from Enclosure 1 to 2 (~0 kW input) |
| Ref. 3 \| Component : Heat Pump \| Function : Consumes 10.4 kW/rack, boosts heat to ~80°C, cools racks to ~35°C |
| Ref. 4 \| Component : sCO₂ Turbine \| Function : Consumes ~0.05 kW/rack, generates ~10.6 kW/rack net electricity |
| Ref. 5 \| Component : Closed-Loop Circuit \| Function : Recycles ~20 kW/rack byproduct heat (9 kW + 11 kW) |

**TABLE 2 - CONTROL SYSTEM COMPONENTS (FIG. 5)**

| |
|---|
| Ref. 1 \| Component : Sensors \| Function : Measure temperature (T), pressure (P), flow rate, GPU power draw |
| Ref. 2 \| Component : PLC \| Function : Runs firmware, processes data, executes PID control and lookup tables |
| Ref. 3 \| Component : VFDs \| Function : Control compressor and valve speeds for dynamic load matching |

## Claims

1. A rack-level energy recovery system for data centers, comprising: a) a first insulated enclosure (Enclosure 1) housing computing equipment that generates waste heat at 40-120°C; b) a second insulated enclosure (Enclosure 2) adjacent to the first insulated enclosure, the second insulated enclosure containing: i) a heat exchanger configured to receive the waste heat from the computing equipment; ii) a heat pump configured to extract the waste heat from the heat exchanger, cool the computing equipment, and output amplified heat at a temperature higher than the waste heat; and iii) a supercritical CO₂ (sCO₂) power cycle utilizing the amplified heat to generate electricity; c) a closed-loop fluid circuit that recycles byproduct heat and cooling from both the heat pump and the sCO₂ power cycle back into the system to increase total heat input to the sCO₂ power cycle by at least 50%; wherein the system achieves net energy recovery with minimal external waste.

2. A modular data center rack system comprising: a) a computing module enclosure (Enclosure 1) with integrated heat capture; b) an adjacent machinery module enclosure (Enclosure 2) with insulated separation; c) fluid and thermal pathways enabling closed-loop energy recovery between the computing module enclosure and the machinery module enclosure; wherein the rack system is configured to integrate with standard 19-inch server racks and supports plug-and-play energy recovery.

3. The system of claim 1, wherein the heat pump boosts the waste heat by 10-60°C using 5-25 kW electrical input.

4. The system of claim 1, wherein the sCO₂ power cycle operates at high-side pressure from 74 bar to 500 bar.

5. The system of claim 1, further comprising variable-speed compressors and sensors for dynamic load matching.

6. The system of claim 1, wherein cooling medium is air, liquid, or immersion-based.

7. The system of claim 1, wherein the computing equipment includes GPUs (graphics processing units), CPUs (central processing units), or AI (artificial intelligence) accelerators consuming from 0.5 kW to at least 500 kW per rack, with all system components scaling proportionally to maintain closed-loop energy recovery and the 2.3× energy multiplier.

8. The system of claim 1, wherein net electrical output is at least 30% of rack power consumption.

9. The system of claim 1, wherein the enclosures are retrofittable to existing data center infrastructure.

10. The system of claim 1, wherein the byproduct heat is recycled to preheat the sCO₂ or assist heat pump evaporation.

11. The system of claim 1, wherein the byproduct heat from the heat pump and the sCO₂ power cycle is recycled to increase total heat input to the turbine by at least 50%, enabling net energy recovery of 30-60% of rack power.
